# EUROPEAN PATENT APPLICATION

(11) **EP 2 209 107 A1**
(43) Date of publication of application: **21.07.2010**
(21) Application number: 10250068.3
(22) Date of filing: 15.01.2010
(51) Int. Cl.: G09G 3/32, G09G 3/36

(54) **Data driver and organic light emitting display device using the same**

(30) Priority: 15.01.2009 KR 20090003272
(71) Applicant: Samsung Mobile Display Co., Ltd., Yongin-city, Gyunggi-do 446-711 (KR)
(72) Inventor: Park, Sung-Un, Chungcheongnam-do (KR); Park, Bong-Oh, Yongin-si Gyeonggi-do (KR)
(74) Representative: Taor, Simon Edward William

(57) **Abstract**

An organic light emitting display device includes a display unit for displaying images in response to data signals and scan signals; a data driver including a first data driving circuit and a second data driving circuit for receiving image signals and for respectively outputting the data signals according to the images signals to corresponding areas of the display unit; a scan driver for outputting the scan signals; and a controller for driving the first data driving circuit and the second data driving circuit independently from one another.

## Description

### BACKGROUND OF THE INVENTION

### 1. Field of the Invention

The present invention relates to a data driver and an organic light emitting display device using the same, and more particularly, to a data driver capable of reducing power consumption and an organic light emitting display device utilizing the same.

### 2. Description of Related Art

Recently, various types of flat panel display devices having reduced weight and volume as compared to cathode ray tubes have been developed. Flat panel display devices include liquid crystal display devices, field emission display devices, plasma display panels, and organic light emitting display devices, among others.

Among these flat panel display devices, organic light emitting display devices display images by utilizing organic light emitting diodes (OLEDs) that emit light through the recombination of electrons and holes.

Since organic light emitting display devices have excellent color reproducibility, slimness, and other desirable properties, their application has widely increased in the markets of mobile phones, PDAs, MP3 players, and other similar devices.

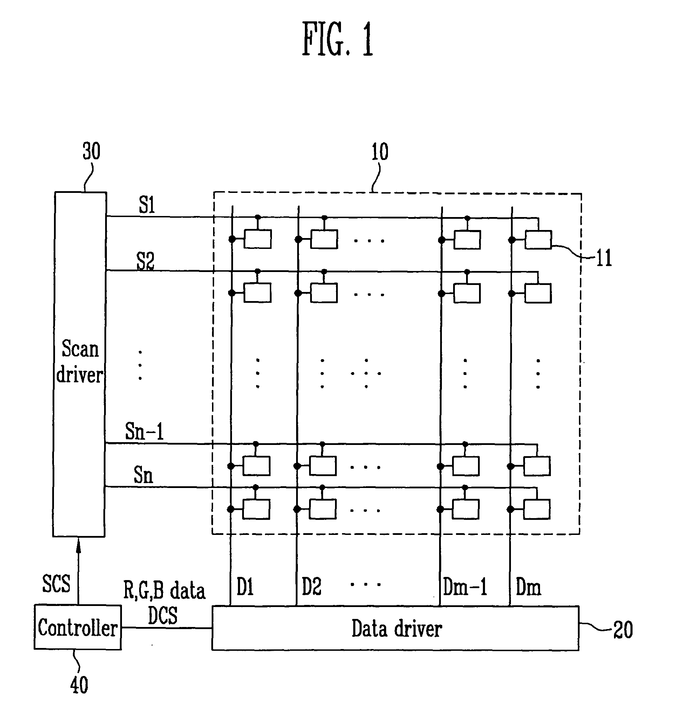

FIG. 1 is a schematic block diagram illustrating the structure of a conventional organic light emitting display device.

Referring to FIG. 1, the organic light emitting display device includes a display unit 10, a data driver 20, a scan driver 30 and a controller 40.

A plurality of pixels 11 are arranged in the display unit 10, and each of the pixels 11 includes an organic light emitting diode for emitting light corresponding to an amount of current. In the display unit 10 are arranged n scan lines S1, S2, ..., Sn-1 and Sn through which scan signals are supplied in a row direction and m data lines D1, D2, ..., Dm-1 and Dm through which data signals are supplied in a column direction.

The display unit 10 is driven by a first power source and a second power source having a lower voltage level than the first power source. Accordingly, current flows through the organic light emitting diodes in accordance with the scan signals, the data signals, the first power source and the second power source, so that the display unit 10 emits light and displays an image.

The data driver 20 receives a data driving control signal DCS and image signals R, G and B data supplied from the controller 40 and generates data signals. The data driver 20 is coupled to the data lines D1, D2, ..., Dm-1 and Dm in the display unit 10 and applies the generated data signals to the display unit 10.

The scan driver 30 receives a scan driving control signal SCS supplied from the controller 40 and generates scan signals. The scan driver 30 is coupled to the scan lines S1, S2, ..., Sn-1 and Sn and sequentially supplies scan signals to specific rows in the display unit 10. A data signal outputted from the data driver 20 is supplied to a pixel 11 to which the scan signal is supplied, such that a voltage corresponding to the data signal is supplied to the pixel 11.

The controller 40 controls the data driver 20 and the scan driver 30, such that an image can be expressed in the display unit 10.

When an organic light emitting display device as described above is used in, for example, a mobile phone, while in a standby mode, an image including a date, a time, or similar information may be displayed only on one area of a display unit, and no image is displayed on the other areas of the display unit.

When an image is displayed on one area as described above, normal driving is also performed on the other areas where no image is displayed, so that the image in the one area can be normally displayed. That is, the data driver 20 outputs data signals to the entire display unit. Therefore, although the data driver 20 is only partially driven in termed of the image that is displayed, the same amount of power is consumed as when the data driver 20 is normally driven (e.g. to show an image on the whole of the display).

### SUMMARY OF THE INVENTION

Accordingly, the present invention provides a data driver having reduced power consumption and an organic light emitting display device using the data driver.

According to an aspect of an exemplary embodiment of the present invention, there is provided an organic light emitting display device, including a display unit for displaying images in response to data signals and scan signals; a data driver including a first data driving circuit and a second data driving circuit for receiving image signals and for respectively outputting the data signals according to the image signals to corresponding areas of the display unit; a scan driver for outputting the scan signals; and a controller for driving the first data driving circuit and the second data driving circuit independently from one another.

According to an aspect of another exemplary embodiment of the present invention, there is provided a data driver including a first data driving circuit including a first shift register for generating a first shift signal, a first latch for receiving first image signals in series corresponding to the first shift signal and for outputting the first image signals in parallel, and a first D/A converter for receiving the first image signals from the first latch and for outputting data signals corresponding to the first image signals; and a second data driving circuit including a second shift register for generating a second shift signal, a second latch for receiving second image signals in series corresponding to the second shift signal and for outputting the second image signals in parallel, and a second D/A converter for receiving the second image signals from the second latch and for outputting data signals corresponding to the second image signals, wherein a controller is configured to generate the first shift signal in response to a first horizontal synchronization signal, and to generate the second shift signal in response to a second horizontal synchronization signal after the first horizontal synchronization signal is generated.

According to a first aspect of the invention there is provided an organic light emitting display device as set out in Claim 1. Preferred features of this aspect are set out in Claims 2 to 9. According to a second aspect of the invention there is provided a data driver as set out in Claim 10. Preferred features of this aspect are set out in Claims 11 to 15.

In a data driver and an organic light emitting display device using the same, according to exemplary embodiments of the present invention, when a plurality of data drivers are provided and an image is displayed on only an area of a display unit, only some data drivers from the plurality of data drivers can be driven, thereby reducing power consumption.

### BRIEF DESCRIPTION OF THE DRAWINGS

The accompanying drawings, together with the specification, illustrate exemplary embodiments of the present invention, and together with the description, serve to explain the principles of the present invention.

FIG. 1 is a schematic block diagram illustrating the structure of a conventional organic light emitting display device.

FIG. 2 is a schematic block diagram illustrating the structure of an organic light emitting display device according to an embodiment of the present invention.

FIG. 3 is a schematic block diagram illustrating the structure of a data driver shown in FIG. 2.

### DETAILED DESCRIPTION OF EXEMPLARY EMBODIMENTS

Hereinafter, certain exemplary embodiments according to the present invention will be described with reference to the accompanying drawings. Here, when a first element is described as being coupled to a second element, the first element may be directly coupled to the second element, or may be indirectly coupled to the second element via one or more additional elements. Further, some of the elements that are not essential to the complete understanding of the invention are omitted for clarity. Also, like reference numerals refer to like elements throughout.

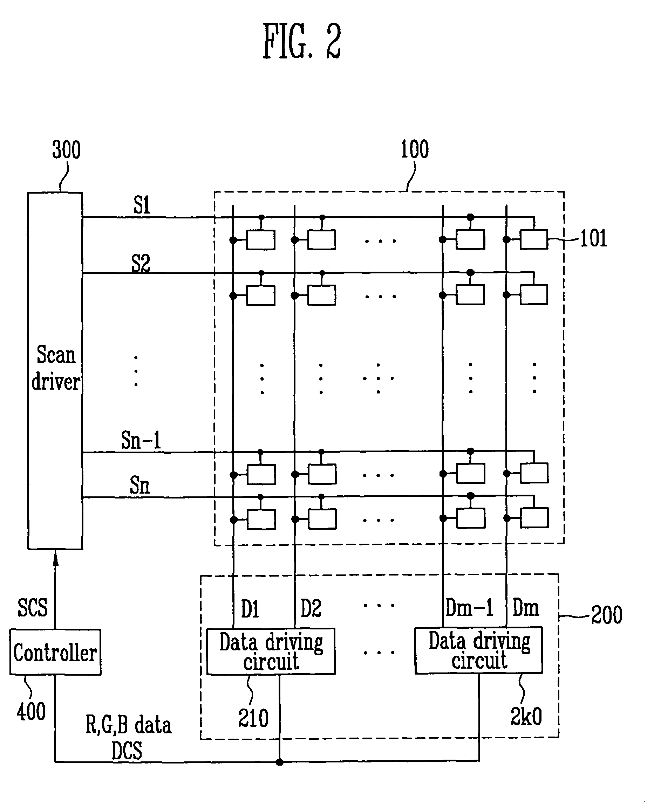

FIG. 2 is a schematic block diagram illustrating the structure of an organic light emitting display device according to an embodiment of the present invention.

Referring to FIG. 2, the organic light emitting display device includes a display unit 100, a data driver 200, a scan driver 300 and a controller 400.

A plurality of pixels 101 are arranged in the display unit 100, and each of the pixels 101 includes an organic light emitting diode which emits light corresponding to an amount of current. In the display unit 100 there are arranged n scan lines S1, S2, ..., Sn-1 and Sn through which scan signals are supplied in a row direction and m data lines D1, D2, ..., Dm-1 and Dm through which data signals are supplied in a column direction.

The display unit 100 is driven by receiving a first power source and a second power source having a lower voltage level than the first power source. Accordingly, current flows through the organic light emitting diodes in accordance with the scan signals, the data signals, the first power source and the second power source, so that the display unit 100 emits light for displaying an image.

The data driver 200 receives a data driving control signal DCS and image signals R, G and B data from the controller 400 and generates data signals. The data driver 200 is coupled to the data lines D1, D2, ..., Dm-1 and Dm in the display unit 100 and applies the generated data signals to the display unit 100. The data driver 200 includes a plurality of data driving circuits 210, ..., and 2k0 and determines whether all the data driving circuits or only certain data driving circuits will be operated.

If some data driving circuits of the plurality of data driving circuits are operated, a data signal is supplied to only an area (e.g., a predetermined area) of the display unit 100 so that an image is displayed on a portion of the display unit 100.

The scan driver 300 receives a scan driving control signal SCS from the controller 400 and generates scan signals. The scan driver 300 is coupled to the scan lines S1, S2, ..., Sn-1 and Sn and supplies a scan signal to a specific row in the display unit 100. A data signal outputted from the data driver 200 is supplied to a pixel 101 to which the scan signal is supplied so that a voltage corresponding to the data signal is supplied to the pixel 101.

The controller 400 controls an image to be expressed in the display unit 100 by supplying the image signals R, G and B data and the data driving control signal DCS to the data driver 200 and supplying the scan driving control signal SCS to the scan driver 300. Particularly, the controller 400 determines which data driving circuits to be driven from among the plurality of data driving circuits.

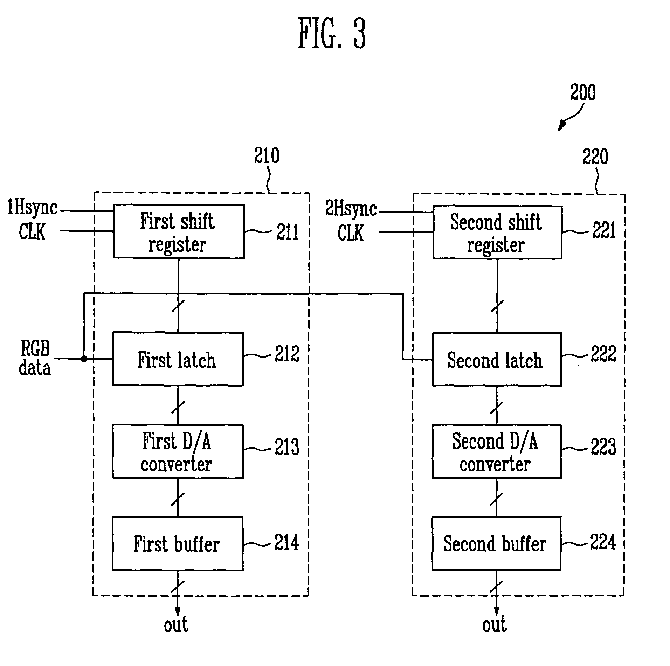

FIG. 3 is a block diagram showing the structure of a data driver shown in FIG. 2. The data driver includes a plurality of data driving circuits. For convenience of illustration, the data driver in FIG. 3 includes two data driving circuits, represented by first and second data driving circuits 210 and 220, respectively.

Referring to FIG. 3, the first data driving circuit 210 includes a first shift register 211, a first latch 212, a first digital/analog (D/A) converter 213 and a first buffer 214. The second data driving circuit 220 includes a second shift register 221, a second latch 222, a second D/A converter 223 and a second buffer 224.

The first and second data driving circuits 210 and 220 are driven by receiving first and second horizontal synchronization signals 1Hsync and 2Hsync, respectively. When both of the first and second data driving circuits 210 and 220 are driven, the controller 400 controls the first and second horizontal synchronization signals 1Hsync and 2Hsync to be supplied to the first and second data driving circuits 210 and 220, respectively. When only the first data driving circuit 210 is driven, the controller 400 supplies the first horizontal synchronization signal 1Hsync to the first driving circuit 210, but does not supply the second horizontal synchronization signal 2Hsync to the second data driving circuit 220. When only the second data driving circuit 220 is driven, the controller 400 supplies the second horizontal synchronization signal 2Hsync to the second driving circuit 220, but does not supply the first horizontal synchronization signal 1Hsync to the first data driving circuit 210. At this time, after a time (e.g., a predetermined time) elapses from when the first horizontal synchronization signal 1Hsync was or would have been supplied to the first data driving circuit 210, the second horizontal synchronization signal 2Hsync is supplied to the second data driving circuit 220.

First, if both the first and second horizontal synchronization signals 1Hsync and 2Hsync are respectively supplied to the first and second data driving circuits 210 and 220, the image signals R, G and B data supplied from the controller 400 are sequentially supplied to the first and second data driving circuits 210 and 220.

That is, the serially supplied image signals R, G and B data are supplied to the first and second latches 212 and 222 by the first and second shift registers 211 and 221, respectively. At this time, the first shift register 211 is operated by the first horizontal synchronization signal 1Hsync, and the second shift register 221 is then operated by the second horizontal synchronization signal 2Hsync. Accordingly, the image signals are first inputted to the first latch 212, and the image signals are then inputted to the second latch 222. When the input of the image signals R, G and B data to the first and second latches 212 and 222 is finished, the first and second latches 212 and 222 supply in parallel the image signals R, G and B data to the first and second D/A converters 213 and 223, respectively. The first and second D/A converters 213 and 223 convert the image signals R, G and B data to generate data signals and then output the data signals through the first and second buffers 214 and 224, respectively.

If, for example, only the second horizontal synchronization signal 2Hsync is supplied to the second data driving circuit 220, the image signals R, G and B data supplied from the controller 400 is supplied to only the second data driving circuit 220.

That is, the operation of the first data driving circuit 210 is stopped, and the data signals R, G and B data are supplied to the second latch 222 in accordance with the second shift register 221 in the second data driving circuit 220. The second latch 222 outputs in parallel the image signals R, G and B data to the second D/A converter 223. The second D/A converter 223 converts the image signals R, G and B data to generate data signals and then outputs the data signals through the second buffer 224.

Accordingly, when the data driver 200 is partially driven, only the second data driving circuit 220 is operated or driven, thereby saving power consumption.

Therefore, embodiments of the present invention provide an organic light emitting display device in which the data driver comprises a plurality of data driving circuits. Each said data driving circuit receives image signals and respectively outputs data signals according to the image signals to a corresponding area of the display unit. The controller drives said data driving circuit independently from one another. Therefore, image signals can be selectively applied to only the areas of the display unit that correspond to the data driving circuits that are being driven.

In other words, each data driving circuit supplies image signals to different areas of the display. By driving each data driving circuit independently, it is only necessary to supply image signals to those parts of the display that are intended to show an image. Therefore, parts of the display which are not to show an image, need not receive image signals.

While the present invention has been described in connection with certain exemplary embodiments, it is to be understood that the invention is not limited to the disclosed embodiments, but is instead intended to cover various modifications and equivalent arrangements included within the scope of the appended claims, and equivalents thereof.

## Claims

1. An organic light emitting display device, comprising:
a display unit for displaying images in response to data signals and scan signals;
a data driver comprising a first data driving circuit and a second data driving circuit for receiving image signals and for respectively outputting the data signals according to the image signals to corresponding areas of the display unit;
a scan driver for outputting the scan signals; and
a controller for driving the first data driving circuit and the second data driving circuit independently from one another.

2. An organic light emitting display device according to claim 1, wherein when the first data driving circuit and the second data driving circuit are both driven, the image signals are sequentially supplied to the first data driving circuit and the second data driving circuit.

3. An organic light emitting display device according to claim 1 or 2, wherein when only one of the first data driving circuit or the second data driving circuit is driven, the image signals are supplied to only the data driving circuit that is driven.

4. An organic light emitting display device according to any one of claims 1 to 3, wherein:
the first data driving circuit comprises a first shift register for generating a first shift signal, a first latch for receiving first image signals of the image signals in series corresponding to the first shift signal and for outputting the first image signals in parallel, and a first D/A converter for receiving the first image signals from the first latch and for outputting the data signals corresponding to the first image signals; and
the second data driving circuit comprises a second shift register for generating a second shift signal, a second latch for receiving second image signals of the image signals in series corresponding to the second shift signal and for outputting the second image signals in parallel, and a second D/A converter for receiving the second image signals from the second latch and for outputting the data signals corresponding to the second image signals.

5. An organic light emitting display device according to claim 4, wherein the controller is configured to generate the first shift signal in response to a first horizontal synchronization signal, and to generate the second shift signal in response to a second horizontal synchronization signal after the first horizontal synchronization signal is generated.

6. An organic light emitting display device according to claim 5, wherein when the first data driving circuit is driven but the second data driving circuit is not driven, the first horizontal synchronization signal is supplied to the first data driving circuit, but the second horizontal synchronization signal is not supplied to the second data driving circuit.

7. An organic light emitting display device according to claim 5 or 6, wherein, when the second data driving circuit is driven but the first data driving circuit is not driven, the second horizontal synchronization signal is supplied to the second data diving circuit, but the first horizontal synchronization signal is not supplied to the first data driving circuit.

8. An organic light emitting display device according to claim 7, wherein the second horizontal synchronization signal is supplied to the second data driving circuit after a time when the first horizontal synchronization signal would have been supplied to the first data driving circuit.

9. An organic light emitting display device according to any one of claims 1 to 8, wherein the data driver comprises a plurality of said data driving circuits, each said data driving circuit being for receiving image signals and for respectively outputting the data signals according to the image signals to a corresponding area of the display unit;
wherein the controller is arranged to drive each said data driving circuit independently from one another so that image signals can be selectively applied to only the areas of the display unit that correspond to the data driving circuits that are being driven.

10. A data driver comprising:
a first data driving circuit comprising a first shift register for generating a first shift signal, a first latch for receiving first image signals in series corresponding to the first shift signal and for outputting the first image signals in parallel, and a first D/A converter for receiving the first image signals from the first latch and for outputting data signals corresponding to the first image signals; and
a second data driving circuit comprising a second shift register for generating a second shift signal, a second latch for receiving second image signals in series corresponding to the second shift signal and for outputting the second image signals in parallel, and a second D/A converter for receiving the second image signals from the second latch and for outputting data signals corresponding to the second image signals,
wherein a controller is configured to generate the first shift signal in response to a first horizontal synchronization signal, and to generate the second shift signal in response to a second horizontal synchronization signal after the first horizontal synchronization signal is generated.

11. A data driver according to claim 10, wherein when the first data driving circuit and the second data driving circuit are both driven, the image signals are sequentially supplied to the first data driving circuit and the second data driving circuit.

12. A data driver according to claim 10 or 11, wherein when only one of the first data driving circuit or the second data driving circuit is driven, the image signals are supplied to only the data driving circuit that is driven.

13. A data driver according to claim 12, wherein when the first data driving circuit is driven but the second data driving circuit is not driven, the first horizontal synchronization signal is supplied to the first data driving circuit, but the second horizontal synchronization signal is not supplied to the second data driving circuit.

14. A data driver according to claim 12 or 13, wherein when the second data driving circuit is driven but the first data driving circuit is not driven, second horizontal synchronization signal is supplied to the second data driving circuit, but the first horizontal synchronization signal is not supplied to the first data driving circuit.

15. A data driver according to claim 14, wherein the second horizontal synchronization signal is supplied to the second data driving circuit after a time when the first horizontal synchronization signal would have been supplied to the first data driving circuit.
